# EUROPEAN PATENT APPLICATION

(11) **EP 4 586 456 A1**
(43) Date of publication of application: **16.07.2025**
(21) Application number: 25150303.3
(22) Date of filing: 06.01.2025
(51) Int. Cl.: H02J 7/00, H01M 10/42

(54) **BATTERY MANAGEMENT DEVICE AND BATTERY PACK INCLUDING THE SAME**

(30) Priority: 11.01.2024 KR 20240004859
(71) Applicant: SAMSUNG SDI CO., LTD., Yongin-si, Gyeonggi-do 17084 (KR)
(72) Inventor: JEONG, Hyeoncheol, 17084 Yongin-si (KR)
(74) Representative: Marks & Clerk LLP

(57) **Abstract**

A battery management device, including a first pack terminal (P+) and a second pack terminal (P-), a first battery terminal (B+) and a second battery terminal (B-) to which a battery (110) including a plurality of battery cells is coupled, a charge control switch (C-FET) and a discharge control switch (D-FET) coupled in series between the first pack terminal (P+) and the first battery terminal (B+), a current sensor (Rs) coupled between the first pack terminal (P+) and the first battery terminal (B+) or between the second pack terminal (P-) and the second battery terminal (B-), and a battery controller (120) configured to control the discharge control switch (D-FET), based on a battery current (Ib) detected through the current sensor (Rs), wherein the battery controller (120) is configured to repeat a process of, when detecting a generation of an overdischarge current, temporarily turning off the discharge control switch (D-FET) for a preset delay time and then turning on the discharge control switch (D-FET) back.

## Description

### BACKGROUND

### 1. Field

The present disclosure relates to a battery management device and a battery pack including the same.

### 2. Description of the Related Art

Unlike non-rechargeable primary batteries, secondary batteries are rechargeable batteries. Small batteries are used in small, portable electronic devices such as smartphones, feature phones, laptop computers, digital cameras, and camcorders, while large batteries are widely used in hybrid vehicles, electric vehicles, and energy storage systems. A battery cell is a basic unit of a secondary battery that can use electrical energy by charging and discharging and may include an electrode assembly including an anode and a cathode, a case accommodating the electrode assembly, and an electrode terminal coupled to the electrode assembly, and the like.

A battery module is a battery assembly binding and putting battery cells in a frame by a certain number to protect the battery cells from external shock, heat, or vibration, etc. A battery pack may be completed by equipping at least one battery module with various control and protection systems such as a battery management device and a cooling system. The at least one battery module is referred to as a battery, and the battery management device may include a battery controller, a protection element, and a sensing element, etc., and may be referred to as a battery management system (BMS). The battery controller may be referred to as a microcontroller unit (MCU).

The above-described information disclosed in the background art of the present disclosure is only for improving understanding of the background of the disclosure, and therefore may also include information not constituting the conventional art.

### SUMMARY

One or more embodiments include a battery management device that may be protected from an inrush current or a short current.

However, a technical task to be solved by the present disclosure is not limited to the above-stated tasks, and other tasks not stated can be clearly understood by those skilled in the art from the description of the present disclosure described below.

Additional aspects will be set forth in part in the description which follows and, in part, will be apparent from the description, or may be learned by practice of the presented embodiments of the present disclosure.

According to one or more embodiments, a battery management device, including a first pack terminal and a second pack terminal, a first battery terminal and a second battery terminal to which a battery including a plurality of battery cells is coupled, a charge control switch and a discharge control switch coupled in series between the first pack terminal and the first battery terminal, a current sensor coupled between the first pack terminal and the first battery terminal or between the second pack terminal and the second battery terminal, and a battery controller configured to control the discharge control switch, based on a battery current detected through the current sensor, wherein the battery controller is configured to repeat a process of, when detecting a generation of an overdischarge current, temporarily turning off the discharge control switch for a preset delay time and then turning on the discharge control switch.

According to an example, the battery controller may be configured to determine that the overdischarge current has been generated when a magnitude of the battery current is more than a preset threshold for a preset time.

According to an example, the battery controller may be configured to determine whether a short protection condition is achieved, and repeat the process when the short protection condition is not achieved.

According to an example, the battery controller may be configured to count the number of times of temporarily turning off the discharge control switch, and determine that the short protection condition is achieved when the number is more than a preset reference number.

According to an example, the battery controller may be configured to count an elapsed time after first detecting the overdischarge current, and determine that the short protection condition is achieved when the elapsed time is longer than a preset reference time.

According to an example, the battery management device may further include a first transient voltage suppression diode coupled in parallel with the discharge control switch.

According to an example, the battery management device may further include a second transient voltage suppression diode coupled between the first pack terminal and the second pack terminal.

According to an example, the battery management device may include a gate driver configured to control the discharge control switch, based on a discharge control signal from the battery controller.

According to an example, the gate driver may be configured to turn off the discharge control switch when a drain current of the discharge control switch is more than a preset threshold for a preset time.

According to an example, the charge control switch and the discharge control switch are each a field effect transistor having a body diode.

According to one or more embodiments, a battery management device includes a first pack terminal and a second pack terminal, a first battery terminal and a second battery terminal to which a battery including a plurality of battery cells is coupled, a charge control switch and a discharge control switch coupled in series between the first pack terminal and the first battery terminal, a first transient voltage suppression diode coupled in parallel with the discharge control switch, a current sensor coupled between the first pack terminal and the first battery terminal or between the second pack terminal and the second battery terminal, and a battery controller configured to control the discharge control switch, based on a battery current detected through the current sensor.

According to an example, the battery management device may further include a second transient voltage suppression diode coupled between the first pack terminal and the second pack terminal.

According to an example, the battery controller may be configured to repeat a process of, when a magnitude of the battery current is more than a preset threshold for a preset time, temporarily turning off the discharge control switch for a preset delay time and then turning on the discharge control switch.

According to an example, the battery controller may be configured to count the number of times of temporarily turning off the discharge control switch, and repeat the process when the number is less than or equal to a preset reference number. The battery controller may be configured to repeat the process when the number satisfies a threshold amount.

According to an example, the battery controller may be configured to count an elapsed time after first detecting the overdischarge current, and repeat the process when the elapsed time is less than or equal to a preset reference time. The battery controller may be configured to repeat the process if the elapsed time satisfies a threshold amount.

According to an example, the battery management device may further include a gate driver configured to control the discharge control switch, based on a discharge control signal from the battery controller. The gate driver may be configured to turn off the discharge control switch when a drain current of the discharge control switch is more than a preset threshold for a preset time.

According to one or more embodiments, a battery pack includes a first pack terminal and a second pack terminal, a battery including a plurality of battery cells coupled between a first battery terminal and a second battery terminal, a charge control switch and a discharge control switch coupled in series between the first pack terminal and the first battery terminal, a first transient voltage suppression diode coupled in parallel with the discharge control switch, a second transient voltage suppression diode coupled between the first pack terminal and the second pack terminal, a gate driver configured to control the discharge control switch, based on a discharge control signal, and a battery controller configured to output the discharge control signal to the gate driver, and control the charge control switch, wherein the gate driver may be configured to turn off the discharge control switch when a drain current of the discharge control switch is more than a preset threshold for a preset time.

According to an example, the battery controller may be configured to, when the discharge control switch is turned off after a turn-on control signal for turning on the discharge control switch is output to the gate driver, wait for a preset delay time and then output the turn-on control signal again.

According to an example, the battery controller may be configured to perform an operation of again outputting the turn-on control signal up to a preset reference number, and perform a short protection operation when the discharge control switch is turned off even if the operation of again outputting the turn-on control signal is performed by the preset reference number.

According to an example, the charge control switch and the discharge control switch may each be a field effect transistor having a body diode.

At least some of the above and other features of the invention are set out in the claims.

### BRIEF DESCRIPTION OF THE DRAWINGS

Features will become apparent to those of skill in the art by describing in detail example embodiments with reference to the attached drawings. The following drawings exemplify embodiments, and serve to further understand the technical idea of the present disclosure together with the detailed description of the present disclosure to be described later. Therefore, the present disclosure should not be interpreted as limited to only items described in such drawings, in which:
FIG. 1 shows a construction of a battery pack including a battery, a battery controller, and an electrical load according to an example embodiment.
FIG. 2A is a graph showing a gate voltage of a discharge control switch at a time point of coupling a link capacitor to a battery pack according to an example embodiment.
FIG. 2B is a graph showing a source voltage of a discharge control switch at a time point of coupling a link capacitor to a battery pack according to an example embodiment.
FIG. 2C is a graph showing an inrush current of a discharge control switch at a time point of coupling a link capacitor to a battery pack according to an example embodiment.
FIG. 3 is a graph showing a safe operation region of a discharge control switch according to an example embodiment.
FIG. 4 is a flowchart showing an operation of a battery controller according to an example embodiment.
FIG. 5A shows a first pack terminal voltage waveform according to example embodiments.
FIG. 5B shows a discharge control switch gate-source voltage waveform according to example embodiments.
FIG. 5C shows an inrush current waveform according to example embodiments.
FIG. 5D shows a discharge control switch drain-source voltage waveform according to example embodiments.
FIG. 6 shows a battery pack including a first transient voltage suppression diode, a second transient voltage suppression diode and a gate driver according to an example embodiment.
FIG. 7 shows a battery pack according to an example embodiment.
FIG. 8 shows a battery pack including a first transient voltage suppression diode according to an example embodiment.
FIG. 9 shows a battery pack including a second transient voltage suppression diode according to an example embodiment.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art.

In the drawing figures, the dimensions of layers and regions may be exaggerated for clarity of illustration. It will also be understood that if a layer or element is referred to as being "on" another layer or substrate, it can be directly on the other layer or substrate, or intervening layers may also be present. Further, it will be understood that if a layer is referred to as being "under" another layer, it can be directly under, and one or more intervening layers may also be present. In addition, it will also be understood that if a layer is referred to as being "between" two layers, it can be the only layer between the two layers, or one or more intervening layers may also be present. Like reference numerals refer to like elements throughout.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," if preceding a list of elements, modify the entire list of elements and do not modify the individual elements of the list.

Embodiments will be described below in detail with reference to the attached drawings. Prior to this, the terms or words used in this specification and claims should not be interpreted as limited to their usual or dictionary meanings, and should be interpreted as meaning and concept consistent with the technical idea of the present disclosure, based on a principle that the inventor may appropriately define the concept of terms in order to explain his or her invention in the best way. Accordingly, the embodiments described in this specification and the constructions shown in the drawings are only some embodiments and do not represent the entire technical idea of the present disclosure, so it should be understood that there may be various equivalents and modified examples that may replace them at the time of filing this application.

When used in this specification, "comprise, include" and/or "comprising, including" specify the presence of stated shapes, numbers, steps, operations, members, elements and/or groups thereof, and do not exclude the presence or addition of one or more other shapes, numbers, operations, members, elements and/or groups. When describing embodiments, "may" and "may be" may include "one or more embodiments".

To help understanding of the present disclosure, the attached drawings are not drawn to an actual scale and the dimensions of some components may be exaggerated. Also, the same reference numerals may be assigned to the same components in different embodiments.

Stating that two comparison objects are 'the same' means that they are `substantially the same'. Therefore, substantial the same may include a deviation considered low in the art, e.g., a deviation within 5 %. That any parameter is uniform in a certain region may mean that it is uniform in an average aspect.

Although first, second, etc. are used to describe various components, these components are of course not limited by these terms. These terms are only used to distinguish one component from another component, and a first component may of course be a second component as well, unless specifically stated to the contrary.

Throughout the specification, each component may be singular or plural, unless stated to the contrary. Disposing any component on an "upper portion (or a lower portion)" of a component or "on (or beneath)" the component may mean not only that the component is disposed in contact with an upper surface (or a lower surface) of the component, but also that another component may be located between the component and the any component disposed on (or beneath) the component.

Also, when it is stated that a certain component is "coupled," "combined," or "accessed" to another component, the components may be directly coupled or accessed to each other, but it should be understood that a further component may be located between the respective components, or the respective components may also be "coupled," "combined" or "accessed" through the further component. Also, when it is said that a certain portion is electrically coupled to another portion, this includes not only that they are directly coupled, but also that they are coupled with another element located therebetween.

When referring to "A and/or B" throughout the specification, this means A, B, or A and B, unless specifically stated to the contrary. That is, "and/or" includes all or any combination of a plurality of listed items. When referring to "C to D", this means C or more and D or less, unless specifically stated to the contrary.

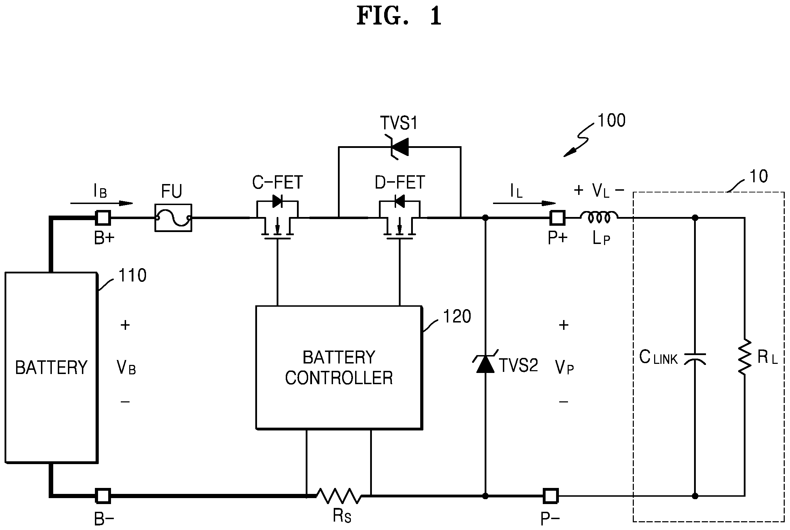

FIG. 1 shows a construction of a battery pack including a battery, a battery controller, and an electrical load according to an example embodiment. Referring to FIG. 1, a battery pack 100 may be coupled to an electrical load 10. The electrical load 10 may have a link capacitor C_{LINK} and a load resistance R_{L}. Wirings or conductive patterns coupling the battery pack 100 with the electrical load 10 may have a parasitic inductance component and may be indicated as a parasitic inductor L_{P} in FIG. 1.

The battery pack 100 may have a first pack terminal P+ and a second pack terminal P-. The first pack terminal P+ is a high-side terminal coupled to a positive electrode of a battery 110, and the second pack terminal P- is a low-side terminal coupled to a negative electrode of the battery 110, but this is an example. In some embodiments the first pack terminal P+ may be a low-side terminal, and the second pack terminal P- may be a high-side terminal.

The battery pack 100 may include the battery 110 and a battery controller 120. The battery 110 may be coupled between a first battery terminal B+ and a second battery terminal B-. The battery 110 is a part that stores power and may include a plurality of battery cells. In an embodiment, the battery cells may include a lithium ion (Li-ion) battery, a lithium polymer (LiPo) battery, a nickel cadmium (Ni-Cd) battery, a nickel metal hydride battery (Ni-MH), a nickel zinc battery (Ni-Zn), or a lead-acid (Pb) battery. As used herein, the term "or" is not an exclusive term, e.g., "A or B" would include A, B, or A and B.

The battery 110 may include a plurality of battery modules, and the battery modules may each include a plurality of battery cells. The number of battery cells and a coupling construction thereof may be determined depending on an output voltage and a power storage capacity required for the battery pack 100.

The battery pack 100 may include a charge control switch C-FET and a discharge control switch D-FET. The charge control switch C-FET may be coupled in series with the discharge control switch D-FET and as shown in FIG. 1, the charge control switch C-FET and the discharge control switch D-FET may be arranged between the first battery terminal B+ and the first pack terminal P+. In some embodiments, the charge control switch C-FET and the discharge control switch D-FET may be arranged at a low-side between the second battery terminal B- and the second pack terminal P-.

The charge control switch C-FET and the discharge control switch D-FET may each be a field effect transistor (FET) having a body diode. In an embodiment, the charge control switch C-FET and the discharge control switch D-FET may be MOSFETs. The charge control switch C-FET may have a body diode with a forward direction aligned with a discharge direction and that blocks the charge of the battery 110 if the charge control switch C-FET is turned off. The discharge control switch D-FET may have a body diode with a forward direction aligned with a charge direction and that blocks the discharge of the battery 110 if the discharge control switch D-FET is turned off.

The charge control switch C-FET and the discharge control switch D-FET may be controlled by the battery controller 120. The battery controller 120 may be configured to control the discharge control switch D-FET, based on a battery current Is. According to an example, the battery controller 120 may directly control the charge control switch C-FET and the discharge control switch D-FET. According to another example, the battery controller 120 may control the discharge control switch D-FET through a gate driver.

According to embodiments, the battery controller 120 may be configured to repeat a process of, if detecting the generation of an overdischarge current, temporarily turning off the discharge control switch D-FET for a preset delay time and then again turning on the discharge control switch D-FET.

The battery pack 100 may include a current sensor Rs. As shown in FIG. 1, the current sensor Rs may be arranged at a low-side between the second battery terminal Band the second pack terminal P-, or may also be arranged at a high-side between the first battery terminal B+ and the first pack terminal P+. The current sensor Rs may be a shunt resistor, and the battery controller 120 may detect a charge current and discharge current of the battery 110, based on a voltage across the current sensor Rs. The battery current Is may be the concept of including the charge current and discharge current of the battery 110, and may, e.g., indicate the discharge current as a positive value and indicate the charge current as a negative value.

As shown in FIG. 1, the battery pack 100 may further include a fuse FU that is broken if a current more than a set magnitude flows. The fuse FU may be arranged at a high-side as shown in FIG. 1 but may also be arranged at a low-side. In one example embodiment, the fuse FU may be arranged between the second battery terminal B- and the current sensor Rs.

The battery pack 100 may further include a first transient voltage suppression (TVS) diode TVS1 coupled in parallel with the discharge control switch D-FET. If the discharge control switch D-FET is turned off, generally, a battery voltage V_{B} between the first battery terminal B+ and the second battery terminal B- may be applied between a drain - source of the discharge control switch D-FET. At this time, it is assumed that the electrical load 10 is coupled to the battery pack 100. However, resonance may occur between the parasitic inductor L_{P} and the link capacitor C_{LINK}, and as power is additionally supplied from the battery 110 through the body diode of the charge control switch C-FET, a difference between the battery voltage V_{B} and an inductor voltage V_{L} across the parasitic inductor L_{P} may be applied to the drain - source of the discharge control switch D-FET. However, if an inrush current I_{L} flowing through the parasitic inductor L_{P} decreases, the inductor voltage V_{L} may have a negative value, and at this time, a voltage higher than the battery voltage V_{B} may be applied to the drain - source of the discharge control switch D-FET. This may damage the discharge control switch D-FET or cause incomplete operation. The first TVS diode TVS1 may clamp a drain - source voltage of the discharge control switch D-FET below a preset voltage, thereby preventing damage to the discharge control switch D-FET.

The battery pack 100 may further include a second TVS diode TVS2 coupled between the first pack terminal P+ and the second pack terminal P-. If the discharge control switch D-FET is turned off, the inrush current I_{L} may continuously flow by the parasitic inductor L_{P}. Accordingly, if the discharge control switch D-FET is in a transient state, a current may flow from the battery 110 to the parasitic inductor L_{P} through the body diode of the charge control switch C-FET. Owing to the current supplied from the battery 110, a resonance between the parasitic inductor L_{P} and the link capacitor C_{LINK} may become larger. The second TVS diode TVS2 may function as a freewheeling diode and may be a circulation path for the inrush current I_{L}. In this regard, the discharge control switch D-FET may reduce a current flowing from the battery 110 to the parasitic inductor L_{P} in the transient state.

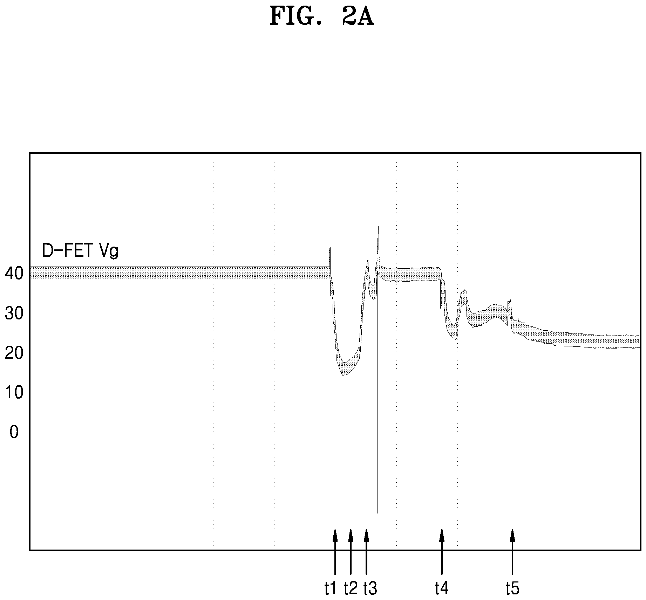

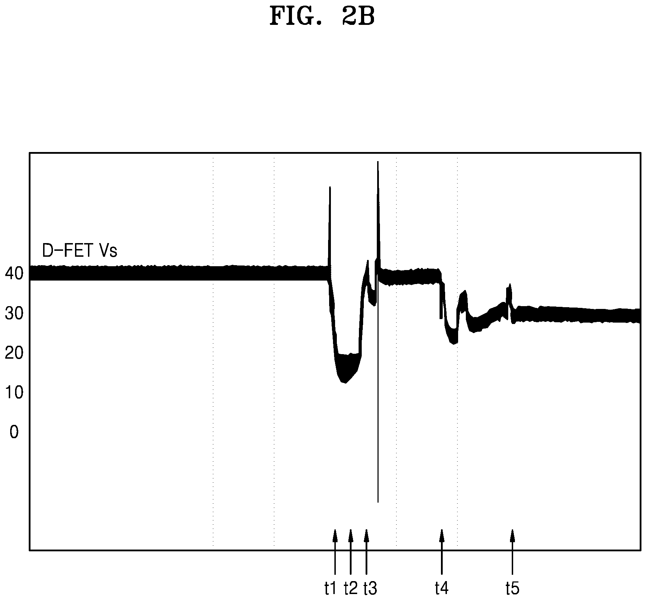

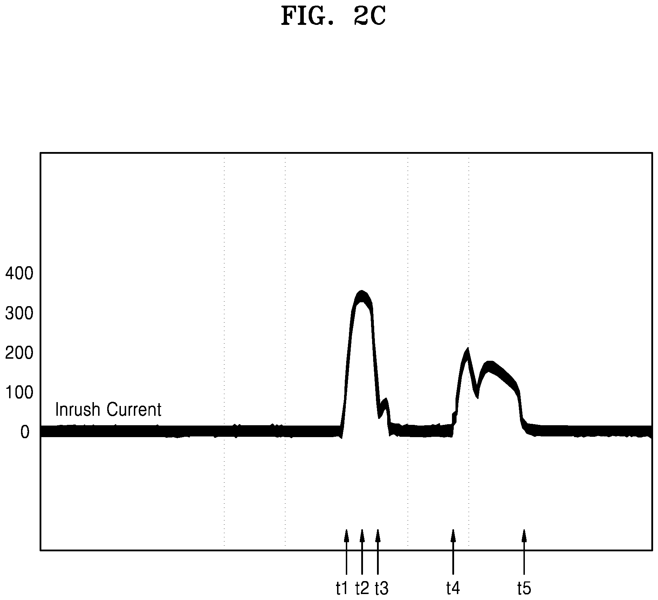

FIG. 2A is a graph showing a gate voltage of a discharge control switch at a time point of coupling a link capacitor to a battery pack according to an example embodiment. FIG. 2B is a graph showing a source voltage of a discharge control switch at a time point of coupling a link capacitor to a battery pack according to an example embodiment. FIG. 2C is a graph showing an inrush current of a discharge control switch at a time point of coupling a link capacitor to a battery pack according to an example embodiment.

Referring to FIGS. 2A to 2C, an inrush current begins to be generated at t1. The inrush current has a maximum value at t2, which is about 350 A. At this time, a drain - source voltage of the discharge control switch D-FET is about 26 V.

The inrush current flows till t3, and a time duration between t1 and t3 is about 100 µs. Also, owing to the inrush current, peak voltages are generated at a gate and source of the discharge control switch D-FET. A source voltage of the discharge control switch D-FET directly coupled to the parasitic inductor L_{P} is varied from about -20 V to about 70 V.

Owing to the inrush current, ringing artifacts may occur between the parasitic inductor L_{P} and the link capacitor C_{LINK}. In this regard, during a time duration between t4 and t5, an inrush current is generated again. After t5, as a voltage of a gate to a source of the discharge control switch D-FET decreases, and the discharge control switch D-FET is turned off.

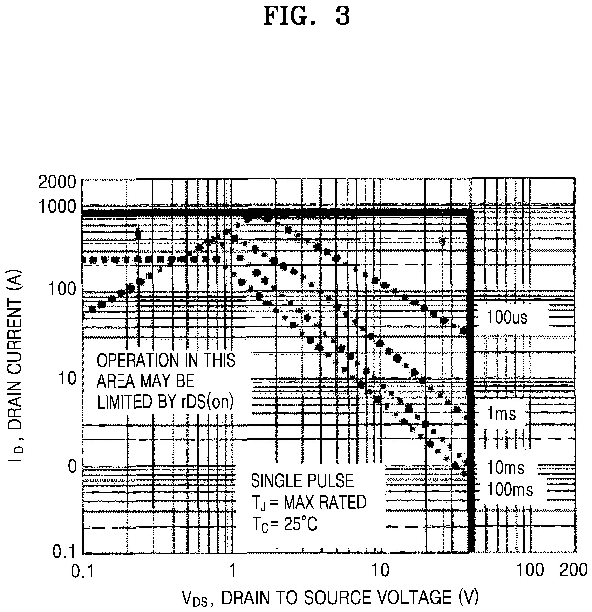

FIG. 3 is a graph showing a safe operation region of a discharge control switch according to an example embodiment. Referring to FIG. 3, if a drain - source voltage is 26 V, an inrush current of 348 A flows for 100 µs, which is out of a safe operation region expressed by a dotted line. This inrush current cannot ensure a normal operation of the discharge control switch D-FET and may even damage the discharge control switch D-FET.

Ringing artifacts may also occur due to a resonance between the parasitic inductor L_{P} and the link capacitor C_{LINK}. In this resonance system, energy is periodically exchanged between the parasitic inductor L_{P} and the link capacitor C_{LINK}. As a result, in a section where the inrush current I_{L} flowing through the parasitic inductor L_{P} decreases or a current flowing from the parasitic inductor L_{P} toward the first battery terminal B+ increases, the inductor voltage V_{L} has a negative value.

Also, if the charge control switch C-FET is turned off, a current may flow from the battery 110 to the parasitic inductor L_{P}, but no current flows to the contrary. In this regard, the battery 110 may supply energy to the resonance system, and a resonance energy of the resonance system may gradually increase. As resonance progresses, a drain - source voltage of the discharge control switch D-FET may become larger.

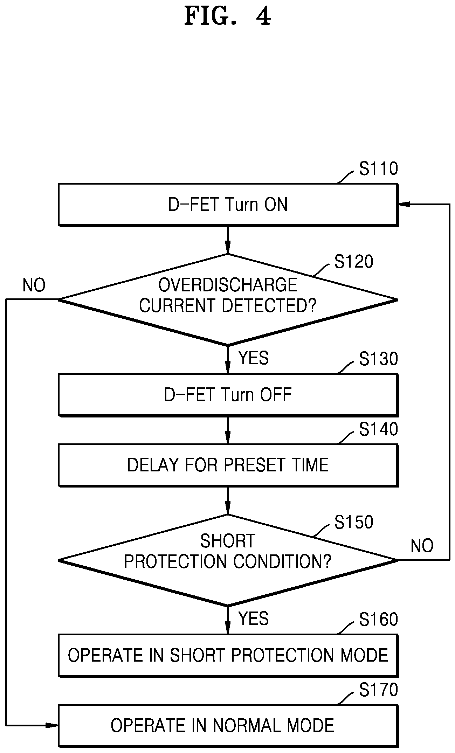

FIG. 4 is a flowchart showing an operation of a battery controller according to an example embodiment. Referring to FIG. 3 and FIG. 4, the battery controller 120 may turn on the discharge control switch D-FET (S110). In an embodiment, if waking up in a sleep state, the battery controller 120 may turn on the discharge control switch D-FET. The battery controller 120 may detect that the electrical load 10 is coupled to the first pack terminal P+ and the second pack terminal P-, and if detecting the coupling of the electrical load 10, the battery controller 120 may turn on the discharge control switch D-FET.

According to an example, at this time, the battery controller 120 may also turn on the charge control switch C-FET. According to another example, the battery controller 120 may turn off the charge control switch C-FET or maintain a turn-off state of the charge control switch C-FET.

The battery controller 120 may detect the generation of an overdischarge current (S 120). In an embodiment, the battery controller 120 may detect a magnitude of a battery current Is by using the current sensor Rs. The battery controller 120 may determine that the overdischarge current has been generated if the battery current Is is more than a preset threshold for a preset time. In an embodiment, the preset time may be 120 µs, and the preset threshold may be 110 A.

If the battery controller 120 does not detect the generation of the overdischarge current, the battery controller 120 may operate in a normal mode of maintaining the discharge control switch D-FET in a turn-on state so that power may be normally supplied from the battery 110 to the electrical load 10 (S 170).

However, if the battery controller 120 detects the generation of the overdischarge current, the battery controller 120 may turn off the discharge control switch D-FET (S 130). The battery controller 120 may maintain the discharge control switch D-FET in a turn-off state for a preset delay time (S140).

The battery controller 120 may determine whether a short protection condition has been achieved (S150). The short protection condition means a condition for considering that a short has occurred in the electrical load 10 and performing a short protection operation after this detection.

If the battery controller 120 determines that the short protection condition has not been achieved, the battery controller 120 may proceed to step S 110 and control the discharge control switch D-FET to be turned on. The battery controller 120 may perform subsequent steps (S120 to S150).

If the battery controller 120 determines that the short protection condition has been achieved, the battery controller 120 may operate in a short protection mode (S160). The battery controller 120 may turn off the discharge control switch D-FET in the short protection mode and end the operation of the flowchart shown in FIG. 4. According to another example, the battery controller 120 may turn off the charge control switch C-FET and the discharge control switch D-FET together in the short protection mode. The battery controller 120 may also turn off the discharge control switch D-FET in the short protection mode and operate in a sleep mode or a shutdown mode.

According to an example, the short protection condition may be that the number of times of performing a process of turning off the discharge control switch D-FET for a delay time may be more than a preset reference number, in a process of repeating steps S110 to S150 if the short protection condition is not achieved in step S150. To this end, the battery controller 120 may count the number of times of performing a process of turning off the discharge control switch D-FET in step S130 or the number of times of performing a process of delaying in a turn-off state in step S140. The battery controller 150 may count the number of times of temporarily turning off the discharge control switch D-FET during a delay time in steps S130 to S140 and determine that the short protection condition is achieved if the number is more than the preset reference number. In an embodiment, if the number is less than or equal to the preset reference number, the battery controller 120 may determine in step S150 that the short protection condition has not been achieved and may proceed to step S 110 and turn on the discharge control switch D-FET.

According to another example, the short protection condition may be that an elapsed time of repeating steps S110 to S150 if the short protection condition is not achieved in step S150 becomes more than a preset reference time. To this end, the battery controller 120 may count an elapsed time elapsed from a time point of first detecting the overdischarge current in step S120. The battery controller 150 may determine that the short protection condition is achieved, if the elapsed time from the time point of first detecting the overdischarge current is longer than the preset reference time. In an embodiment, if the elapsed time is shorter than the preset reference time, the battery controller 120 may determine in step S150 that the short protection condition has not been achieved and may proceed to step S 110 and turn on the discharge control switch D-FET.

In FIG. 4, it is illustrated that step S150 of determining whether the short protection condition is achieved is performed after step S140, but this is an example, and step S150 of determining whether the short protection condition is achieved may be performed after step S120 or step S130, or may be also performed simultaneously with step S130 or step S140.

If a large inrush current flows from the battery 110 to the electrical load 10, steps S110 to S150 may be performed repeatedly, and only while step S120 for detecting an overdischarge current is performed, the discharge control switch D-FET may be in a turn-on state. While step S120 is performed, an inrush current may be output from the battery 110 and be charged to the link capacitor C_{LINK} of the electrical load 10.

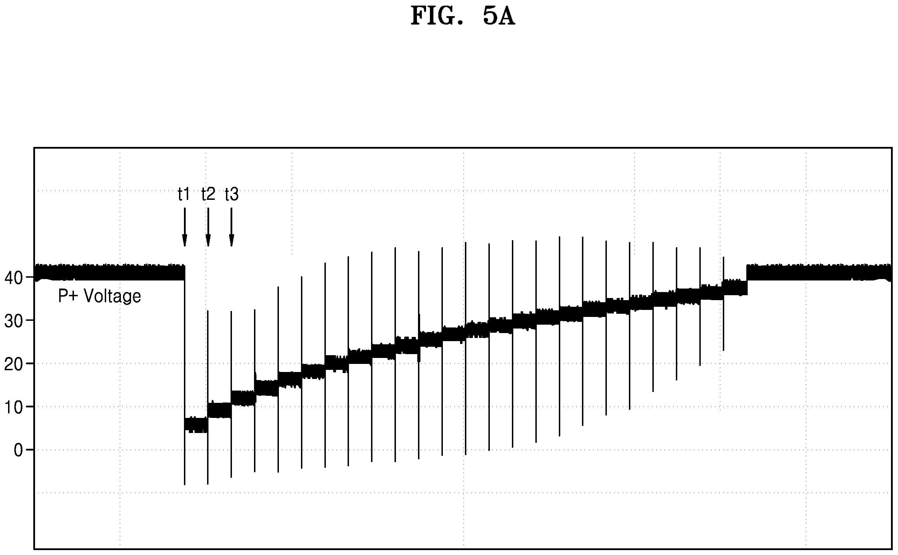

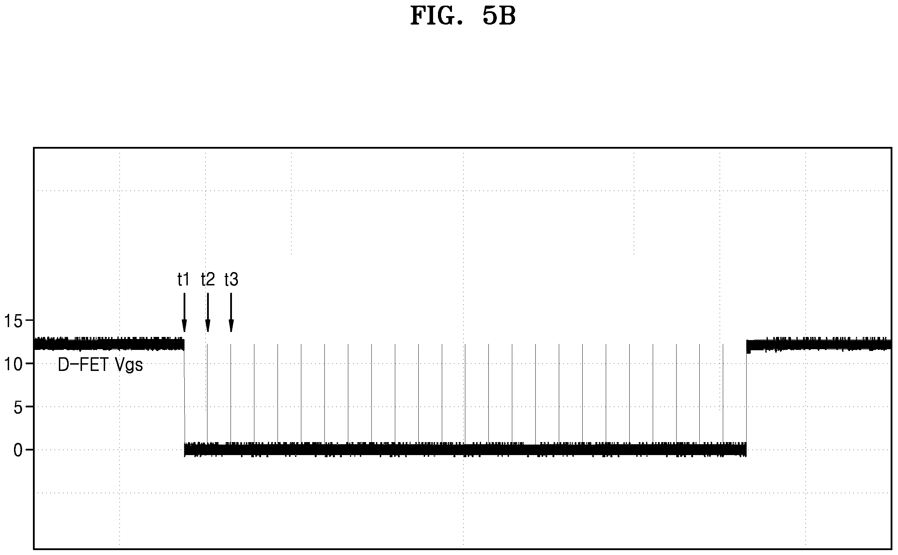

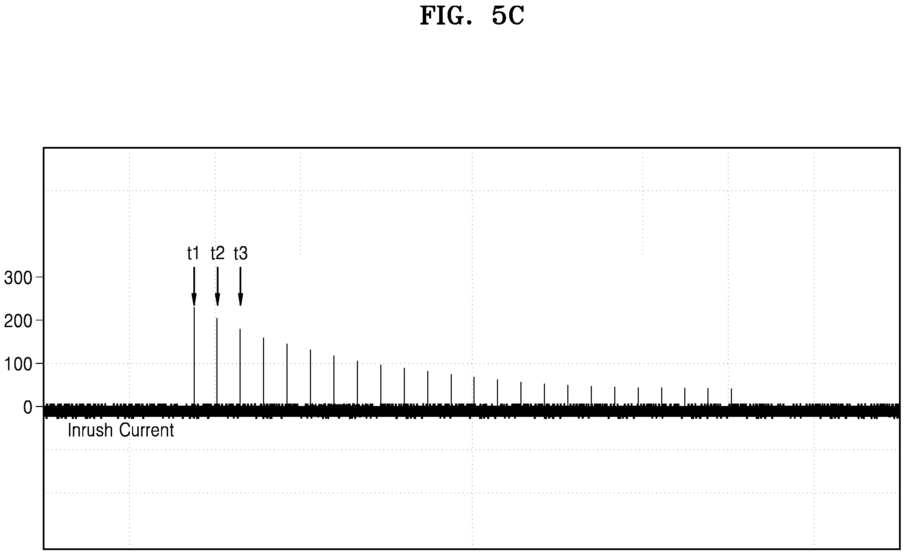

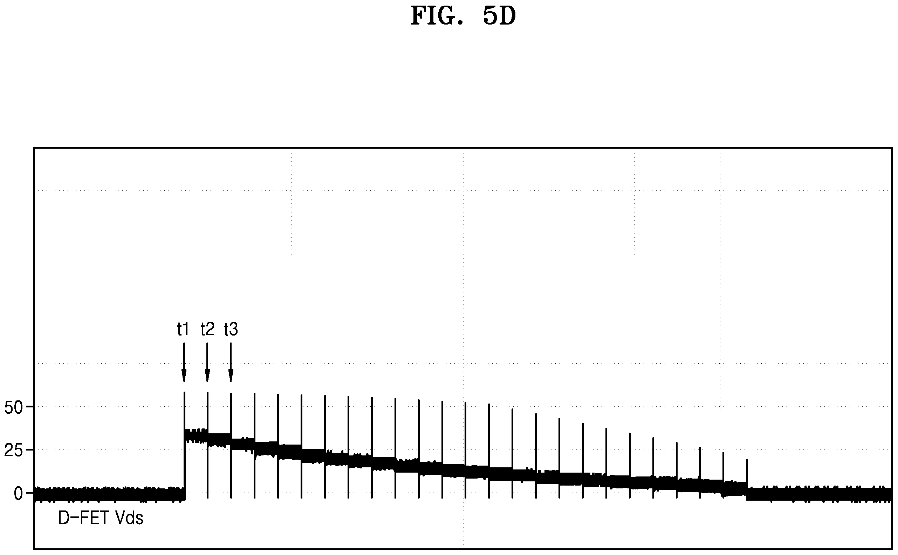

FIG. 5A shows a first pack terminal voltage waveform according to example embodiments. FIG. 5B shows a discharge control switch gate-source voltage waveform according to example embodiments. FIG. 5C shows an inrush current waveform according to example embodiments. FIG. 5D shows a discharge control switch drain-source voltage waveform according to example embodiments.

Waveforms of FIGS. 5A to 5D were measured in a state of turning on the discharge control switch D-FET before t1 and electrically coupling the electrical load 10 having the link capacitor C_{LINK} to the battery 110 at t1. At t1, a voltage across the link capacitor C_{LINK} is very low, almost approaching 0 V.

According to the embodiment shown in FIG. 4, the inrush current I_{L} is temporarily charged to the link capacitor C_{LINK} through the discharge control switch D-FET turned on at t1. However, after step S120 for detecting the overdischarge current, the discharge control switch D-FET is turned off and is maintained in a turn off state for a preset delay time. In this regard, between t1 and t2, the discharge control switch D-FET is in the turn off state, and the inrush current I_{L} does not flow.

At t2 if the preset delay time has elapsed, the discharge control switch D-FET is temporarily turned on. The inrush current I_{L} flows to the link capacitor C_{LINK}. As this process is repeated, a voltage across the link capacitor C_{LINK} increases to approximate the first pack terminal voltage VP+, and the overdischarge current is no longer generated even if the discharge control switch D-FET is turned on. In one embodiment, it took about 656 ms for the link capacitor C_{LINK} to be fully charged, and a delay time of step S140 was preset to about 27.3 ms.

Also, a drain - source voltage Vds of the discharge control switch D-FET was limited to a peak value of 62.5 V. This is because the first TVS diode TVS1 having a breakdown voltage of 68 V is coupled in parallel with the discharge control switch D-FET.

The first pack terminal voltage VP+ was 41.2 V at t1 but was limited to a peak value of 49.4 V throughout the entire process shown in FIG. 5A. This is because the second TVS diode TVS2 having a breakdown voltage of 48 V is coupled between the first pack terminal P+ and the second pack terminal P-.

In some embodiments of a battery pack not having the first TVS diode TVS1 and the second TVS diode TVS2, the first pack terminal voltage VP+ and the drain - source voltage Vds of the discharge control switch D-FET would have higher peak values, and these high peak values may damage the discharge control switch D-FET.

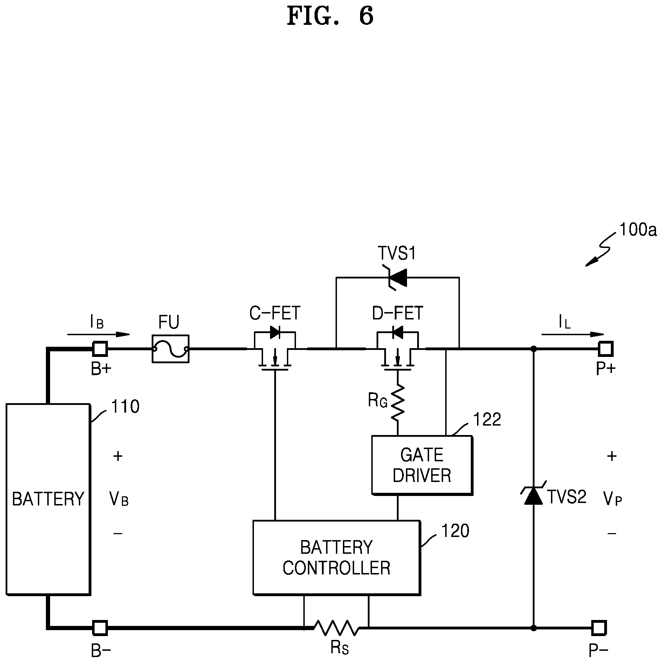

FIG. 6 shows a battery pack including a first TSV diode, a second TSV diode and a gate driver according to an example embodiment. Referring to FIG. 6, a battery pack 100a may include a battery 110 and a battery controller 120.

The battery 110 may be coupled between a first battery terminal B+ and a second battery terminal B- and output a battery current Is. A fuse FU, a charge control switch C-FET, and a discharge control switch D-FET may be coupled in series between the first battery terminal B+ and a first pack terminal P+. A current sensor Rs may be coupled between the second battery terminal B- and a second pack terminal P-. A first TVS diode TVS1 may be coupled in parallel with the discharge control switch D-FET, and a second TVS diode TVS2 may be coupled between the first pack terminal P+ and the second pack terminal P-. The components of FIG. 6 have been described above with reference to FIG. 1 and thus will not be described repeatedly here.

According to this embodiment, the battery controller 120 may directly control the charge control switch C-FET and control the discharge control switch D-FET through a gate driver 122. In an embodiment, the battery controller 120 may output a charge control signal to the charge control switch C-FET and output a discharge control signal to the gate driver 122. The gate driver 122 may be coupled to a gate of the discharge control switch D-FET through a gate resistor R_{G}, and may be directly coupled to a source of the discharge control switch D-FET. The gate driver 122 may control a gate - source voltage of the discharge control switch D-FET, based on the discharge control signal from the battery controller 120, thereby controlling an operation of the discharge control switch D-FET. The gate driver 122 may detect a drain current of the discharge control switch D-FET and may turn off the discharge control switch D-FET and protect the discharge control switch D-FET if the drain current is more than a preset reference value.

According to embodiments, the battery controller 120 may be configured to repeat a process of temporarily turning off the discharge control switch D-FET for a preset delay time and then again turning on the discharge control switch D-FET, if the battery controller 120 is detecting a generation of an overdischarge current based on the battery current I_{B} detected through the current sensor Rs.

According to another embodiment, the gate driver 122 may turn off the discharge control switch D-FET, if a drain current of the discharge control switch D-FET is more than a preset threshold for a preset time. The battery controller 120 may be configured to wait for a preset delay time and then again output a turn-on control signal, if the discharge control switch D-FET is turned off after a turn-on control signal for turning on the discharge control switch D-FET is output to the gate driver 122.

In an embodiment, the battery controller 120 may output a turn-on control signal for turning on the discharge control switch D-FET to the gate driver 122. In response to the turn-on control signal, the gate driver 122 may turn on the discharge control switch D-FET. At this time, if a large inrush current I_{L} flows to the link capacitor C_{LINK}, the gate driver 122 may detect that the large inrush current I_{L}, being more than a preset threshold, flows for a preset time. if this large inrush current I_{L} is more than the preset threshold for more than the preset time and flows through a drain current of the discharge control switch D-FET, the gate driver 122 may turn off the discharge control switch D-FET for short protection.

The battery controller 120 may detect that the discharge control switch D-FET is turned off. The battery controller 120 may wait for a preset delay time and then again output a turn-on control signal to the gate driver 122, thereby turning on the discharge control switch D-FET. By repeating this process, the battery controller 120 may divide the inrush current by a short time and supply it to the link capacitor C_{LINK}, until the link capacitor C_{LINK} is charged.

The battery controller 120 may be configured to perform an operation of again outputting a turn-on control signal up to a preset reference number, and determine that short has occurred in the electrical load 10 and perform a short protection operation, if the discharge control switch D-FET is turned off even if the operation of again outputting the turn-on control signal is performed by the preset reference number.

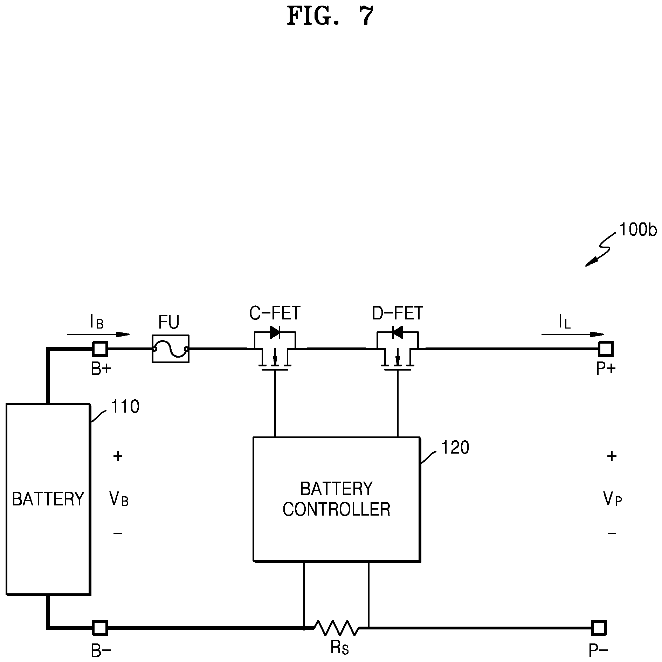

FIG. 7 shows a battery pack according to an example embodiment. Referring to FIG. 7, a battery pack 100b may include a battery 110 and a battery controller 120. The battery 110 may be coupled between a first battery terminal B+ and a second battery terminal B-, and output a battery current Is. A fuse FU, a charge control switch C-FET, and a discharge control switch D-FET may be coupled in series between the first battery terminal B+ and a first pack terminal P+. A current sensor Rs may be coupled between the second battery terminal B- and a second pack terminal P-.

Compared to the battery pack 100 of FIG. 1, the battery pack 100b of FIG. 7 does not include the first TVS diode TVS1 coupled in parallel with the discharge control switch D-FET and the second TVS diode TVS2 coupled between the first pack terminal P+ and the second pack terminal P-. As shown in FIG. 7, the battery pack 100b of this embodiment may not include the first TVS diode TVS1 and the second TVS diode TVS2.

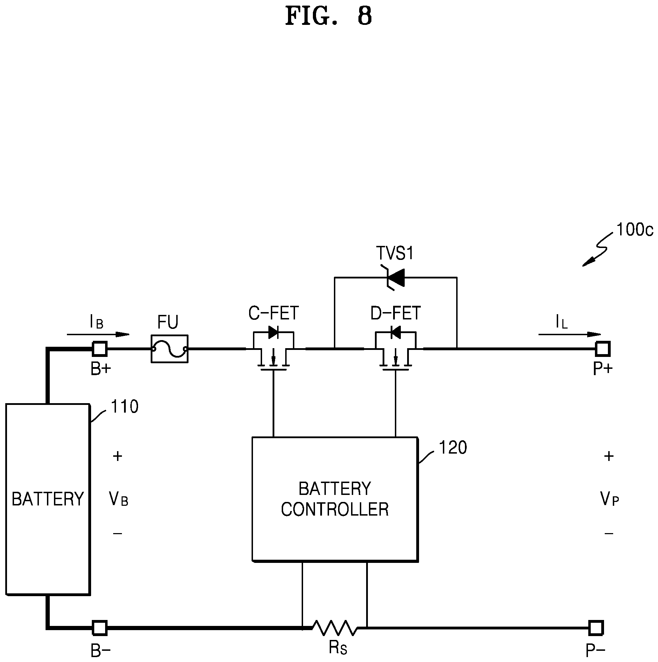

FIG. 8 shows a battery pack including a first TSV diode according to an example embodiment. Referring to FIG. 8, a battery pack 100c may include a battery 110 and a battery controller 120.

The battery 110 may be coupled between a first battery terminal B+ and a second battery terminal B-, and output a battery current I_{B}. A fuse FU, a charge control switch C-FET, and a discharge control switch D-FET may be coupled in series between the first battery terminal B+ and a first pack terminal P+. A current sensor Rs may be coupled between the second battery terminal B- and a second pack terminal P-. A first TVS diode TVS1 may be coupled in parallel with the discharge control switch D-FET.

Compared to the battery pack 100 of FIG. 1, the battery pack 100c of FIG. 8 does not include the second TVS diode TVS2 coupled between the first pack terminal P+ and the second pack terminal P-. As shown in FIG. 8, the battery pack 100c of this embodiment may not include the second TVS diode TVS2.

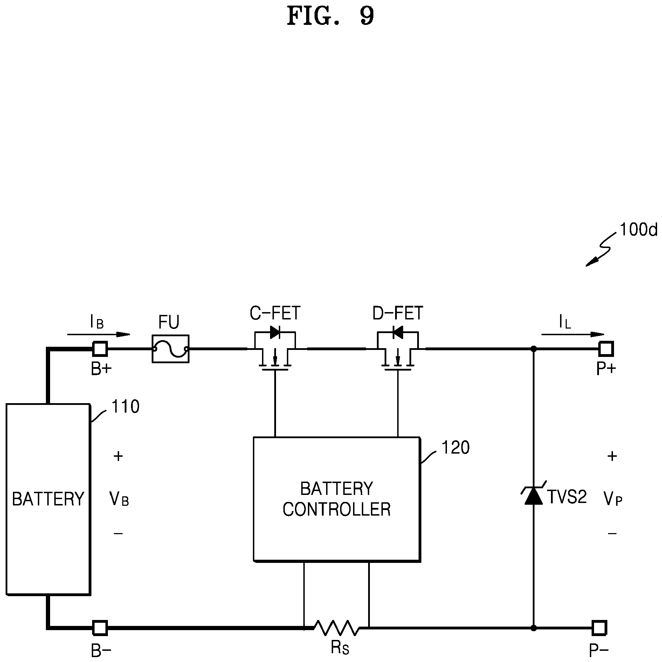

FIG. 9 shows a battery pack including a second TSV diode according to an example embodiment. Referring to FIG. 9, a battery pack 100d may include a battery 110 and a battery controller 120.

The battery 110 may be coupled between a first battery terminal B+ and a second battery terminal B-, and output a battery current I_{B}. A fuse FU, a charge control switch C-FET, and a discharge control switch D-FET may be coupled in series between the first battery terminal B+ and a first pack terminal P+. A current sensor Rs may be coupled between the second battery terminal B- and a second pack terminal P-. A second TVS diode TVS2 may be coupled between the first pack terminal P+ and the second pack terminal P-.

Compared to the battery pack 100 of FIG. 1, the battery pack 100d of FIG. 9 does not include the first TVS diode TVS1 coupled in parallel with the discharge control switch D-FET. As shown in FIG. 9, the battery pack 100d of this embodiment may not include the first TVS diode TVS1.

By way of summation and review, if the battery pack is coupled to an electrical load having a DC-link capacitor, a very large inrush current may flow from a battery to the link capacitor. Also, if short occurs in the electrical load, a very large discharge current may be output from the battery. To prevent this very large current from damaging the battery cells, a discharge control switch must be turned off quickly, but the discharge control switch may be damaged as a very large current flows through a drain and a large voltage is applied between a drain and source of the discharge control switch.

To prevent this, a precharge current path capable of charging the link capacitor with a low current can be provided in parallel with the discharge control switch. However, there is a disadvantage in which switches are increased in number to additionally create the precharge current path.

One or more embodiments include a battery pack that may be protected from an inrush current or a short current.

According to the present disclosure, elements such as switches or fuses of a battery management device may be protected from a large inrush current that flows while charging a link capacitor of an electrical load if the electrical load is coupled to a battery pack. Also, if short actually occurs in the electrical load, the battery management device may distinguish a short current and an inrush current and perform a short protection operation.

However, effects obtainable through the present disclosure are not limited to the above-stated effects, and other technical effects not stated will be clearly understood by those skilled in the art from the description of the present disclosure.

Specific implementation examples shown and described in this specification are examples for explanation, and are not intended to limit the scope of embodiments in any way. For the sake of brevity, the description of conventional electronic components, control systems, software, and other functional aspects of the systems may be omitted. Also, couplings or coupling members of lines between components shown in the drawings exemplarily represent functional couplings and/or physical or circuit couplings, and in actual devices, may be implemented as replaceable or additional various functional couplings, physical couplings, or circuit couplings.

In describing the embodiments (particularly, the claims), the use of the term "above" and similar referential terms may correspond to all the singular and the plural. Also, when a range is described in the embodiments, the range includes the application of individual values belonging to the above range (unless stated to the contrary), and is the same as each individual value constituting the range is described in the detailed description of the present disclosure. Unless there is an explicit statement of order or a statement to the contrary regarding steps constituting a method of the present disclosure, the above steps may be performed in any suitable order. The present disclosure is not necessarily limited by the order of description of the above steps.

The use of all example terms (e.g., etc.) in the present disclosure is merely to describe the present disclosure in detail, and unless limited by the claims, the scope of the embodiments is not limited by the example terms. Also, those skilled in the art may know that various modifications, combinations and changes may be made depending on a design condition and factor within the scope of the appended claims or their equivalents.

Embodiments are presented in this specification, and although specific terms are used, such terms are not used for the purpose of limitation but should be interpreted as general and descriptive. In some examples, features and/or components described in relation to a specific embodiment may be used alone, unless specifically stated otherwise, and may also be used together with features and/or components described in relation to other embodiments, as the features and/or components will be apparent to those skilled in the art at the time of filing this application. Therefore, the present disclosure should not be limited to the above-described embodiments, and not only the scope of the claims described below but also all scopes equivalent to or equivalently changed from the scope of the claims will be said to pertain to the scope of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

Embodiments are set out in the following clauses:
Clause 1. A battery management device comprising:
   a first pack terminal and a second pack terminal;
   a first battery terminal and a second battery terminal to which a battery comprising a plurality of battery cells is coupled;
   a charge control switch and a discharge control switch coupled in series between the first pack terminal and the first battery terminal;
   a current sensor coupled between the first pack terminal and the first battery terminal or between the second pack terminal and the second battery terminal; and
   a battery controller configured to control the discharge control switch, based on a battery current detected through the current sensor,
   wherein the battery controller is configured to repeat a process of, when detecting the generation of an overdischarge current, temporarily turning off the discharge control switch for a preset delay time and then turning on the discharge control switch.
Clause 2. The battery management device of clause 1, wherein the battery controller is configured to determine that the overdischarge current has been generated when a magnitude of the battery current is more than a preset threshold for a preset time.
Clause 3. The battery management device of clause 1 or clause 2, wherein the battery controller is configured to determine whether a short protection condition is achieved, and repeat the process when the short protection condition is not achieved.
Clause 4. The battery management device of clause 3,
   wherein the battery controller is configured to count the number of times of temporarily turning off the discharge control switch, and determine that the short protection condition is achieved when the number is more than a preset reference number.
Clause 5. The battery management device of clause 3 or clause 4, wherein the battery controller is configured to count an elapsed time after first detecting the overdischarge current, and determine that the short protection condition is achieved when the elapsed time is longer than a preset reference time.
Clause 6. The battery management device of any of clauses 1 to 5, further comprising a first transient voltage suppression (TVS) diode coupled in parallel with the discharge control switch.
Clause 7. The battery management device of any of clauses 1 to 6, further comprising a second TVS diode coupled between the first pack terminal and the second pack terminal.
Clause 8. The battery management device of any of clauses 1 to 7, further comprising a gate driver configured to control the discharge control switch, based on a discharge control signal from the battery controller.
Clause 9. The battery management device of clause 8,
   wherein the gate driver is configured to turn off the discharge control switch when a drain current of the discharge control switch is more than a preset threshold for a preset time.
Clause 10. The battery management device of any of clauses 1 to 9,
   wherein the charge control switch and the discharge control switch are each a field effect transistor (FET) having a body diode.
Clause 11. A battery management device comprising:
   a first pack terminal and a second pack terminal;
   a first battery terminal and a second battery terminal to which a battery comprising a plurality of battery cells is coupled;
   a charge control switch and a discharge control switch coupled in series between the first pack terminal and the first battery terminal;
   a first transient voltage suppression (TVS) diode coupled in parallel with the discharge control switch;
   a current sensor coupled between the first pack terminal and the first battery terminal or between the second pack terminal and the second battery terminal; and
   a battery controller configured to control the discharge control switch, based on a battery current detected through the current sensor.
Clause 12. The battery management device of clause 11,
   further comprising a second TVS diode coupled between the first pack terminal and the second pack terminal.
Clause 13. The battery management device of clause 11 or clause 12, wherein the battery controller is configured to repeat a process of, when a magnitude of the battery current is more than a preset threshold for a preset time, temporarily turning off the discharge control switch for a preset delay time and then turning on the discharge control switch.
Clause 14. The battery management device of clause 13, wherein the battery controller is configured to count the number of times of temporarily turning off the discharge control switch, and repeat the process when the number is less than or equal to a preset reference number.
Clause 15. The battery management device of clause 13 or clause 14, wherein the battery controller is configured to count an elapsed time after first detecting the overdischarge current, and repeat the process when the elapsed time is less than or equal to a preset reference time.
Clause 16. The battery management device of any of clauses 11 to 15, further comprising a gate driver configured to control the discharge control switch, based on a discharge control signal from the battery controller, wherein the gate driver is configured to turn off the discharge control switch when a drain current of the discharge control switch is more than a preset threshold for a preset time.
Clause 17. A battery pack comprising:
   a first pack terminal and a second pack terminal;
   a battery comprising a plurality of battery cells coupled between a first battery terminal and a second battery terminal;
   a charge control switch and a discharge control switch coupled in series between the first pack terminal and the first battery terminal;
   a first transient voltage suppression (TVS) diode coupled in parallel with the discharge control switch;
   a second TVS diode coupled between the first pack terminal and the second pack terminal;
   a gate driver configured to control the discharge control switch, based on a discharge control signal; and
   a battery controller configured to output the discharge control signal to the gate driver, and control the charge control switch,
   wherein the gate driver is configured to turn off the discharge control switch when a drain current of the discharge control switch is more than a preset threshold for a preset time.
Clause 18. The battery pack of clause 17, wherein the battery controller is configured to, when the discharge control switch is turned off after a turn-on control signal for turning on the discharge control switch is output to the gate driver, wait for a preset delay time and then output the turn-on control signal again.
Clause 19. The battery pack of clause 17 or clause 18, wherein the battery controller is configured to perform an operation of again outputting the turn-on control signal up to a preset reference number, and perform a short protection operation when the discharge control switch is turned off even if the operation of again outputting the turn-on control signal is performed by the preset reference number.
Clause 20. The battery pack of any of clauses 17 to 19, wherein the charge control switch and the discharge control switch are each a field effect transistor (FET) having a body diode.

## Claims

1. A battery management device, comprising:
a first pack terminal and a second pack terminal;
a first battery terminal and a second battery terminal to which a battery including a plurality of battery cells is coupled;
a charge control switch and a discharge control switch coupled in series between the first pack terminal and the first battery terminal;
a current sensor coupled between the first pack terminal and the first battery terminal or between the second pack terminal and the second battery terminal; and
a battery controller configured to control the discharge control switch, based on a battery current detected through the current sensor,
wherein the battery controller is configured to repeat a process of, when detecting a generation of an overdischarge current, temporarily turning off the discharge control switch for a preset delay time and then turning on the discharge control switch.

2. The battery management device of claim 1, wherein the current sensor is coupled in series with the battery between the first pack terminal and the second pack terminal.

3. The battery management device as claimed in claim 1 or claim 2, wherein the battery controller is configured to determine that the overdischarge current has been generated when a magnitude of the battery current is more than a preset threshold for a preset time.

4. The battery management device as claimed in any preceding claim, wherein the battery controller is configured to determine whether a short protection condition is achieved, and repeat the process when the short protection condition is not achieved.

5. The battery management device as claimed in claim 4, wherein the battery controller is configured to count a number of times of temporarily turning off the discharge control switch, and determine that the short protection condition is achieved when the number of times of temporarily turning off the discharge control switch is more than a preset reference number.

6. The battery management device as claimed in claim 4 or claim 5, wherein the battery controller is configured to count an elapsed time after first detecting the overdischarge current, and determine that the short protection condition is achieved when the elapsed time is longer than a preset reference time.

7. The battery management device as claimed in any preceding claim, further comprising a first transient voltage suppression diode coupled in parallel with the discharge control switch.

8. The battery management device as claimed in any preceding claim, further comprising a second transient voltage suppression diode coupled between the first pack terminal and the second pack terminal.

9. The battery management device as claimed in any preceding claim, further comprising a gate driver configured to control the discharge control switch, based on a discharge control signal from the battery controller.

10. The battery management device as claimed in claim 9, wherein the gate driver is configured to turn off the discharge control switch when a drain current of the discharge control switch is more than a preset threshold for a preset time.

11. The battery management device as claimed in any preceding claim, wherein the charge control switch and the discharge control switch are each a field effect transistor having a body diode.

12. A battery pack, comprising:
a first pack terminal and a second pack terminal;
a battery including a plurality of battery cells coupled between a first battery terminal and a second battery terminal;
a charge control switch and a discharge control switch coupled in series between the first pack terminal and the first battery terminal;
a first transient voltage suppression diode coupled in parallel with the discharge control switch;
a second transient voltage suppression diode coupled between the first pack terminal and the second pack terminal;
a gate driver configured to control the discharge control switch, based on a discharge control signal; and
a battery controller configured to output the discharge control signal to the gate driver, and control the charge control switch,
wherein the gate driver is configured to turn off the discharge control switch when a drain current of the discharge control switch is more than a preset threshold for a preset time.

13. The battery pack as claimed in claim 12, wherein the battery controller is configured to, when the discharge control switch is turned off after a turn-on control signal for turning on the discharge control switch is output to the gate driver, wait for a preset delay time and then output the turn-on control signal again.

14. The battery pack as claimed in claim 12 or claim 13, wherein the battery controller is configured to perform an operation of again outputting the turn-on control signal up to a preset reference number, and perform a short protection operation when the discharge control switch is turned off even if the operation of again outputting the turn-on control signal is performed by the preset reference number.

15. The battery pack as claimed in any of claims 12 to 14, wherein the charge control switch and the discharge control switch are each a field effect transistor having a body diode.
